# EUROPEAN PATENT APPLICATION

(11) **EP 4 365 935 A1**
(43) Date of publication of application: **08.05.2024**
(21) Application number: 22205283.9
(22) Date of filing: 03.11.2022
(51) Int. Cl.: H01L 23/053, H01L 23/373, H01L 23/04, H01L 23/488, H01L 23/49, H01L 23/48, H01L 21/60

(54) **POWER SEMICONDUCTOR MODULE ARRANGEMENT**

(71) Applicant: Infineon Technologies AG, 85579 Neubiberg (DE)
(72) Inventor: STEIN, Markus, 59494 Soest (DE); SCHMER, Alexander, 59494 Soest (DE)
(74) Representative: Westphal, Mussgnug & Partner, Patentanwälte mbB

(57) **Abstract**

A power semiconductor module arrangement comprises a housing, a substrate forming a ground surface of the housing, one or more holding pins mechanically connected to the substrate, and one or more holding elements attached to or integrally formed with the housing, wherein a first end of each of the one or more holding pins is arranged inside the housing and connected to the substrate, each of the one or more holding elements comprises a sleeve configured to receive a free end of one of the holding pins, and each of the one or more holding pins extends from the substrate in a vertical direction perpendicular to a top surface of the substrate towards a different one of the one or more holding elements such that the free end of each of the one or more holding pins is arranged inside the respective holding element in order to form a force-fitting connection.

## Description

### TECHNICAL FIELD

The instant disclosure relates to a power semiconductor module arrangement, in particular to a power semiconductor module arrangement comprising a housing.

### BACKGROUND

Power semiconductor module arrangements often include a substrate within a housing. The substrate usually comprises a substrate layer (e.g., a ceramic layer), a first metallization layer deposited on a first side of the substrate layer and, optionally, a second metallization layer deposited on a second side of the substrate layer. A semiconductor arrangement including one or more controllable semiconductor elements (e.g., two IGBTs in a half-bridge configuration) may be arranged on the substrate. One or more terminal elements (contact elements), which allow for contacting such a semiconductor arrangement from outside the housing, are usually provided. The housing may be glued to the substrate in order to remain in a desired position until the substrate is permanently attached to a base plate or heat sink by means of additional connecting elements. Gluing the housing to the substrate requires additional pretreatment steps (e.g., a plasma treatment of the substrate), a step in which the glue is applied to the substrate, as well as a hardening step in which the originally viscous glue is hardened, thereby attaching the housing to the substrate. Each additional step during the assembly process requires additional process time and increases the overall cost of the power semiconductor module arrangement.

There is a need for a power semiconductor module arrangement that may be assembled in an effective and cost-efficient way.

### SUMMARY

A power semiconductor module arrangement includes a housing, a substrate forming a ground surface of the housing, one or more holding pins mechanically connected to the substrate, and one or more holding elements attached to or integrally formed with the housing, wherein a first end of each of the one or more holding pins is arranged inside the housing and connected to the substrate, each of the one or more holding elements includes a sleeve configured to receive a free end of one of the holding pins, and each of the one or more holding pins extends from the substrate in a vertical direction perpendicular to a top surface of the substrate towards a different one of the one or more holding elements such that the free end of each of the one or more holding pins is arranged inside the respective holding element in order to form a force-fitting connection.

A method for assembling a power semiconductor module arrangement includes mechanically connecting one or more holding pins to a substrate, and arranging a housing on the substrate, wherein one or more holding elements are attached to or integrally formed with the housing, a first end of each of the one or more holding pins is arranged inside the housing and connected to the substrate, each of the one or more holding elements includes a sleeve configured to receive a free end of one of the one or more holding pins, and each of the one or more holding pins extends from the substrate in a vertical direction perpendicular to a top surface of the substrate towards a different one of the one or more holding elements, and arranging the housing on the substrate comprises pressing the free end of each of the one or more holding pins into a different one of the one or more holding elements in order to form a force-fitting connection.

The invention may be better understood with reference to the following drawings and the description. The components in the figures are not necessarily to scale, emphasis instead being placed upon illustrating the principles of the invention. Moreover, in the figures, like referenced numerals designate corresponding parts throughout the different views.

### BRIEF DESCRIPTION OF THE DRAWINGS

Figure 1 is a schematic cross-sectional view of a power semiconductor module arrangement.
Figure 2 is a schematic three-dimensional view of a housing for a power semiconductor module arrangement according to one example.
Figure 3 schematically illustrates a section of the housing of Figure 2 including a holding element according to one example in further detail.
Figure 4 schematically illustrates a holding element according to another example.
Figure 5, including Figures 5A to 5C, schematically illustrates cross-sectional views of holding elements according to different examples.
Figure 6 is a schematic three-dimensional view of a substrate according to one example with holding pins mounted thereon.
Figure 7 is a schematic cross-sectional view of a section of a power semiconductor module arrangement according to one example.
Figure 8 is a schematic cross-sectional view of a holding element and a holding pin in an unmounted state according to an example.
Figure 9 is a schematic cross-sectional view of the holding element and holding pin of Figure 8 in a mounted state.
Figure 10 is a schematic three-dimensional view of a housing for a power semiconductor module arrangement according to another example.
Figure 11 is a schematic three-dimensional view of a housing for a power semiconductor module arrangement according to an even further example.
Figure 12 is a schematic three-dimensional cross-sectional view of a power semiconductor module arrangement according to an even further example.
Figure 13 is a schematic cross-sectional view of a holding element and holding pin according to the example of Figure 12.
Figure 14 schematically illustrates a housing for a power semiconductor module arrangement according to an even further example.
Figure 15 schematically illustrates exemplary cross-sections of a holding pin and holding element according to an embodiment of the disclosure.

### DETAILED DESCRIPTION

In the following detailed description, reference is made to the accompanying drawings. The drawings show specific examples in which the invention may be practiced. It is to be understood that the features and principles described with respect to the various examples may be combined with each other, unless specifically noted otherwise. In the description as well as in the claims, designations of certain elements as "first element", "second element", "third element" etc. are not to be understood as enumerative. Instead, such designations serve solely to address different "elements". That is, e.g., the existence of a "third element" does not require the existence of a "first element" and a "second element". A semiconductor body as described herein may be made from (doped) semiconductor material and may be a semiconductor chip or may be included in a semiconductor chip. A semiconductor body has electrically connecting pads and includes at least one semiconductor element with electrodes.

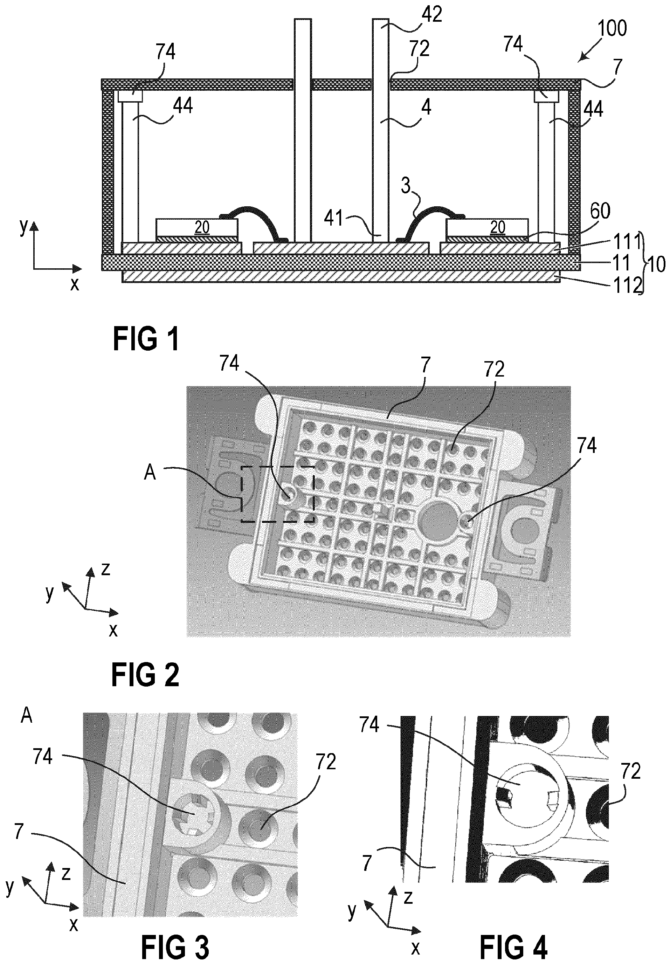

Referring to Figure 1, a cross-sectional view of a power semiconductor module arrangement 100 is illustrated. The power semiconductor module arrangement 100 includes a housing 7 and a substrate 10. The substrate 10 includes a dielectric insulation layer 11, a (structured) first metallization layer 111 attached to the dielectric insulation layer 11, and a (structured) second metallization layer 112 attached to the dielectric insulation layer 11. The dielectric insulation layer 11 is disposed between the first and second metallization layers 111, 112.

Each of the first and second metallization layers 111, 112 may consist of or include one of the following materials: copper; a copper alloy; aluminum; an aluminum alloy; any other metal or alloy that remains solid during the operation of the power semiconductor module arrangement. The substrate 10 may be a ceramic substrate, that is, a substrate in which the dielectric insulation layer 11 is a ceramic, e.g., a thin ceramic layer. The ceramic may consist of or include one of the following materials: aluminum oxide; aluminum nitride; zirconium oxide; silicon nitride; boron nitride; or any other dielectric ceramic. Alternatively, the dielectric insulation layer 11 may consist of an organic compound and include one or more of the following materials: Al₂O₃, AIN, SiC, BeO, BN, or Si₃N₄. For instance, the substrate 10 may, e.g., be a Direct Copper Bonding (DCB) substrate, a Direct Aluminum Bonding (DAB) substrate, or an Active Metal Brazing (AMB) substrate. Further, the substrate 10 may be an Insulated Metal Substrate (IMS). An Insulated Metal Substrate generally comprises a dielectric insulation layer 11 comprising (filled) materials such as epoxy resin or polyimide, for example. The material of the dielectric insulation layer 11 may be filled with ceramic particles, for example. Such particles may comprise, e.g., SiO₂, Al₂O₃, AIN, SiN or BN and may have a diameter of between about 1µm and about 50µm. The substrate 10 may also be a conventional printed circuit board (PCB) having a non-ceramic dielectric insulation layer 11. For instance, a non-ceramic dielectric insulation layer 11 may consist of or include a cured resin.

The substrate 10 is arranged in a housing 7. In the example illustrated in Figure 1, the substrate 10 forms a base surface of the housing 7, while the housing 7 itself solely comprises sidewalls and a cover. In some power semiconductor module arrangements 100, more than one substrate 10 is arranged within the same housing 7.

One or more semiconductor bodies 20 may be arranged on the at least one substrate 10. Each of the semiconductor bodies 20 arranged on the at least one substrate 10 may include a diode, an IGBT (Insulated-Gate Bipolar Transistor), a MOSFET (Metal-Oxide-Semiconductor Field-Effect Transistor), a JFET (Junction Field-Effect Transistor), a HEMT (High-Electron-Mobility Transistor), or any other suitable semiconductor element.

The one or more semiconductor bodies 20 may form a semiconductor arrangement on the substrate 10. In Figure 1, only two semiconductor bodies 20 are exemplarily illustrated. The second metallization layer 112 of the substrate 10 in Figure 1 is a continuous layer. According to another example, the second metallization layer 112 may be a structured layer. According to other examples, the second metallization layer 112 may be omitted altogether. The first metallization layer 111 is a structured layer in the example illustrated in Figure 1. "Structured layer" in this context means that the respective metallization layer is not a continuous layer, but includes recesses between different sections of the layer. Such recesses are schematically illustrated in Figure 1. The first metallization layer 111 in this example includes three different sections. Different semiconductor bodies 20 may be mounted to the same or to different sections of the first metallization layer 111. Different sections of the first metallization layer may have no electrical connection or may be electrically connected to one or more other sections using electrical connections 3 such as, e.g., bonding wires. Semiconductor bodies 20 may be electrically connected to each other or to the first metallization layer 111 using electrical connections 3, for example. Electrical connections 3, instead of bonding wires, may also include bonding ribbons, connection plates or conductor rails, for example, to name just a few examples. The one or more semiconductor bodies 20 may be electrically and mechanically connected to the substrate 10 by an electrically conductive connection layer 60. Such an electrically conductive connection layer 60 may be a solder layer, a layer of an electrically conductive adhesive, or a layer of a sintered metal powder, e.g., a sintered silver (Ag) powder, for example.

The power semiconductor module arrangement 100 illustrated in Figure 1 further includes terminal elements 4. The terminal elements 4 are mechanically and electrically connected to the substrate 10 (e.g., to the first metallization layer 111) and provide an electrical connection between the inside and the outside of the housing 7. The terminal elements 4 may be mechanically and electrically connected to the first metallization layer 111 with a first end 41, while a second end 42 of the terminal elements 4 protrudes out of the housing 7. The terminal elements 4 may be electrically contacted from the outside at their second end 42. The housing 7 (i.e., the cover of the housing 7) comprises a plurality of through holes 72. Each of the plurality of terminal elements 4 protrudes vertically through a different one of the plurality of through holes 72.

In addition to the terminal elements 4 described with respect to Figure 1, the components inside the housing 7 may also be electrically contacted from outside the housing 7 in any other suitable way. For example, additional terminal elements 4 may be arranged closer to or adjacent to the sidewalls of the housing 7. It is also possible that terminal elements 4 protrude vertically or horizontally through the sidewalls of the housing 7. The first end 41 of a terminal element 4 may be electrically and mechanically connected to the substrate 10 by an electrically conductive connection layer, for example (not explicitly illustrated in Figure 1). Such an electrically conductive connection layer may be a solder layer, a layer of an electrically conductive adhesive, or a layer of a sintered metal powder, e.g., a sintered silver (Ag) powder, for example. The first end 41 of a terminal element 4 may also be electrically coupled to the substrate 10 via one or more electrical connections 3, for example.

A power semiconductor module arrangement as has been exemplarily described with respect to Figure 1 above is usually assembled by a supplier of the power semiconductor arrangement and is subsequently shipped to a customer. At the customer, the power semiconductor module arrangement is usually arranged on an additional base plate or heat sink, for example. The housing 7 is attached to such a base plate or heat sink by means of dedicated connection elements. The substrate 10 is then securely held between the housing 7 and the base plate or heat sink. However, when shipping the assembled power semiconductor module arrangement 100, the housing 7 also needs to remain in a desired position with regard to the substrate 10, i.e., the housing 7 has to be secured to the substrate 10 in order to not fall off the substrate 10.

The power semiconductor module arrangement, therefore, further comprises one or more holding pins 44 and one or more holding elements 74, wherein each of the one or more holding elements 74 forms a counterpart for one of the one or more holding pins 44. Each of the one or more holding pins 44 may be mechanically connected to the substrate 10 by means of a connection layer, for example (connection layer not explicitly illustrated in Figure 1). Such a connection layer may be any kind of electrically insulating adhesive layer, a solder layer, a layer of an electrically conductive adhesive, or a layer of a sintered metal powder, e.g., a sintered silver (Ag) powder, for example. A holding pin 44 is not required to provide an electrical connection and, therefore, may include any kind of electrically insulating or electrically conductive material. For example, each of the one or more holding pins 44 may comprise a plastic material. It is, however, also possible that each of the one or more holding pins 44 comprises a metal. A holding pin 44, even if comprising an electrically conducting material, may not be electrically coupled to any of the components inside the housing 7, for example. Further, a free end of the holding pin 44 which faces away from the substrate 10 does not extend to the outside of the housing 7. Instead, the free end of the holding pin 44 extends to the holding element 74 and is arranged inside the holding element 74, forming a force-fitting connection with the holding element 74.

Each of the one or more holding elements 74 is either integrally formed with the housing 7 (i.e., with a lid or cover of the housing 7), or is attached to the housing 7 (i.e., with the lid or cover of the housing 7) in any suitable way (e.g., glued to the housing 7). The one or more holding pins 44, when the power semiconductor module arrangement 100 is fully assembled for shipping, extend from the substrate 10 vertically through the housing 7 (perpendicular to a top surface of the substrate 10) and are firmly attached to a respective one of the holding elements 74 (each holding pin 44 forms a force-fitting connection with a different one of the holding elements 74), thereby holding the housing 7 in a desired position with regard to the substrate 10. Each holding pin 44 is pressed into one of the holding elements 74, resulting in a certain holding force. That is, a force that is greater than the holding force is needed in order to remove the holding pin 44 from the holding element 74. The principle may be similar to that of dowel pins inserted into respective counterparts (e.g., blind hole).

Now referring to Figure 2, a housing 7 comprising two holding elements 74 is schematically illustrated. Figure 2 illustrates a schematic view of the inside of the housing 7. The housing 7 in this example has a rectangular shape and comprises four sidewalls and a cover or lid. In this example, one of the two holding elements 74 is arranged centrally along a first sidewall, and the other one of the two holding elements 74 is arranged centrally along a second sidewall, opposite the first sidewall. Providing two holding elements 74 on opposing sides of the housing and inserting the respective holding pins 44 into the holding elements 74 may be sufficient to hold the housing 7 in a desired position with regard to the substrate 10. In some cases, even a single holding element 74 and holding pin 44 may be sufficient, wherein a single holding element 74 may be arranged in a central position of the cover or lid. Instead of rectangular, the housing 7 may have any other suitable shape such as, e.g., a square shape.

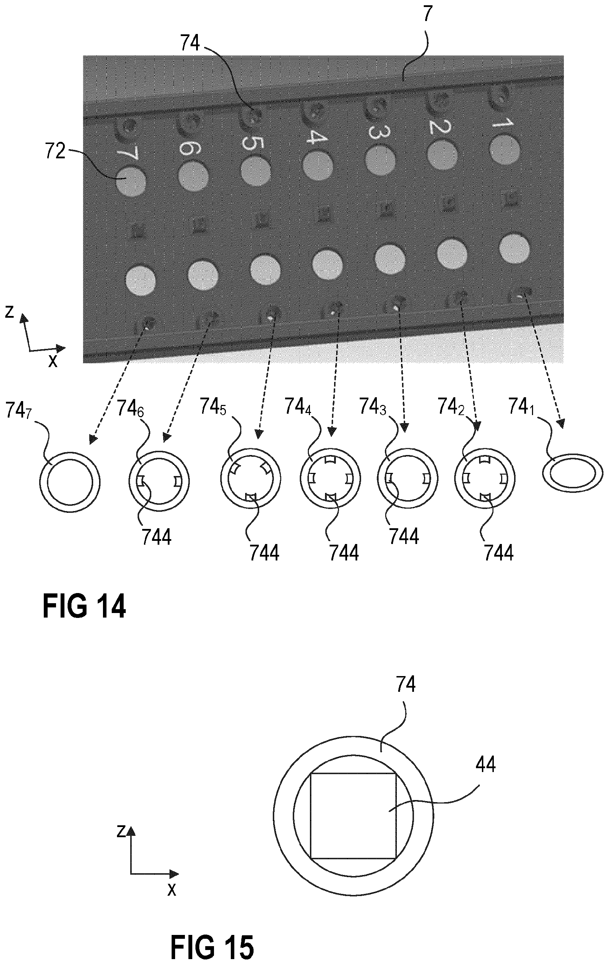

The at least one holding pin 44 may be a simple pin having a round cross-section, for example. Any other cross-section such as, e.g., oval, square, rectangular, or polygonal, however, is also possible. Generally, a holding pin 44 may also have an irregular cross-section. Each of the at least one holding element 74 comprises a sleeve, opening or mouth configured to receive the free end of one of the holding pins 44. The cross-section of a holding element 74 may essentially correspond to the cross-section of the respective holding pin 44. For example, if a holding pin 44 has a round cross-section, the respective holding element 74 may have an essentially round cross-section as well. It is, however, also possible that a holding element 74 as a different cross-section as the respective holding pin 44. For example, a holding element 74 may have a round or oval cross-section, while the respective holding pin 44 has a polygonal cross-section (e.g., square or rectangular cross-section), as is exemplarily illustrated in Figure 15.

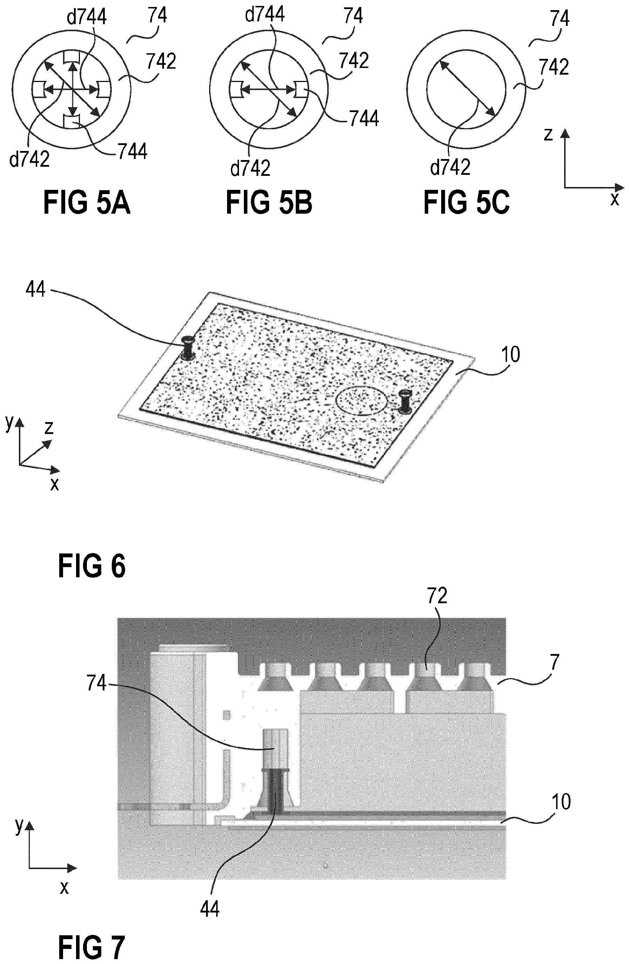

A holding element 74 according to one embodiment of the disclosure is schematically illustrated in Figure 3. In this example, the holding element 74 comprises a sleeve, having an inner diameter and defining an opening, and a plurality of ribs or protrusions extending from the inner diameter of the sleeve towards a center of the opening defined by the sleeve. The ribs reduce the inner diameter of the sleeve in defined sections. The holding element 74 in Figure 3 comprises four ribs arranged in regular intervals around the circumference of the sleeve. Any other number of ribs, however, is also possible. As is schematically illustrated in Figure 4, it is also possible that the holding element 74 comprises two ribs arranged on opposing sides of the sleeve, for example. The examples of Figures 3 and 4 are illustrated in further detail in Figures 5A and 5B. As can be seen in Figures 5A and 5B, the inner diameter d742 of the sleeve 742 is reduced to a reduced diameter d744 by means of the ribs 744. As is schematically illustrated in Figure 5C, however, it is also possible that the holding element 74 does not comprise any ribs 744 at all.

The outer diameter of a round holding pin 44 may be equal to or slightly larger than the reduced diameter d744 and smaller than the inner diameter d742 of the sleeve 742, for example, if the holding element 74 comprises ribs 744. If the holding element 74 does not comprise any ribs 744, the outer diameter of a holding pin 44 may be equal to or slightly larger than the inner diameter d742 of the sleeve 742. That is, a certain force is required in order to insert the holding pin 44 into the holding element 74. A comparably large force is then required in order to remove the holding pin 44 from the respective holding element 74. Therefore, once the holding pins 44 are inserted into the respective holding elements 74, the housing 7 is held in a desired position with regard to the substrate 10 and may not easily be detached from the substrate 10. The principles described with respect to round holding pins 44 and round holding elements 74 similarly apply to holding pins 44 and holding elements 74 having other shapes (e.g., rectangular, square, oval, polygonal, irregular shapes, etc.).

The holding pins 44 may be solid pins, for example. It is, however, also possible that the holding pins 44 are hollow on the inside. It is even possible that a holding pin 44 is or comprises a sleeve. In the latter case, an outer diameter of the holding pin 44 (i.e., of the sleeve) may be larger than the reduced diameter d744 and smaller than the inner diameter d742 of the sleeve 742, for example, if the holding element 74 comprises ribs 744. If the holding element 74 does not comprise any ribs 744, the outer diameter of a holding pin 44 (i.e., of the sleeve) may be larger than the inner diameter d742 of the sleeve 742. For example, an outer diameter of the holding pin 44 may be between 0 and 0.5 mm, or between 0 and 0.2 mm larger than the reduced diameter d744 or than the inner diameter d742 of the holding element 74. In this way, the holding pin 44 may still be inserted into (pressed into) the holding element 74 when applying a certain amount of force (similar to a dowel pin). Once inserted into the holding element 74, however, the holding pin 44 may not easily be detached again

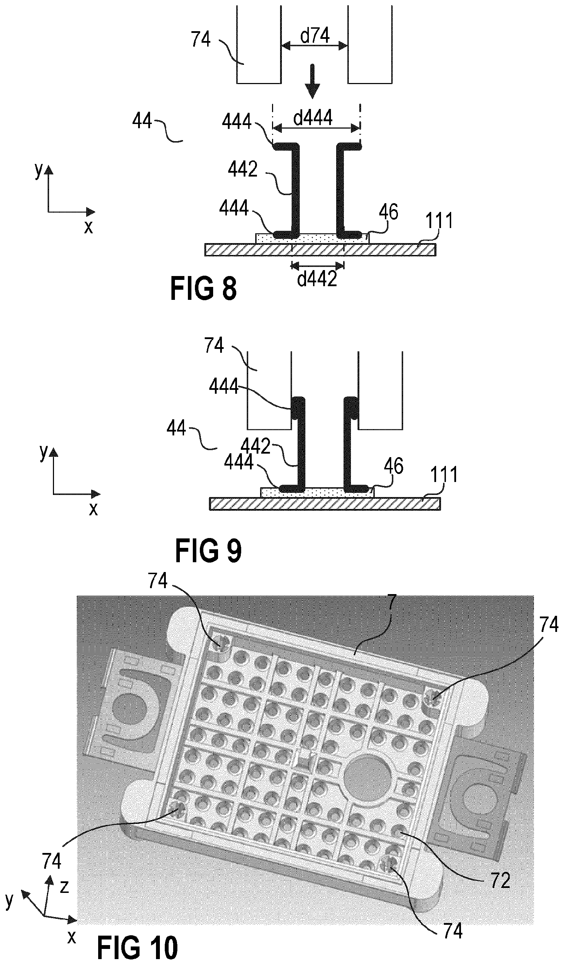

A substrate 10 with two holding pins 44 implemented as sleeves is exemplarily illustrated in Figure 6. Figure 7 schematically illustrates a cross-sectional view of a section of a power semiconductor module arrangement wherein a holding pin 44 implemented as a sleeve is inserted into a respective holding element 74. As is illustrated in Figures 6 and 7, and in further detail in Figures 8 and 9, a holding pin 44 (e.g., a sleeve 442) may comprise at least one collar 444 arranged at the free end of the holding pin 44. In the example illustrated in Figures 8 and 9, the holding pin 44 comprises two collars 444, wherein each collar 444 is arranged at a different end of the holding pin 44. As has been described above, a first end of the holding pin 44 is attached to the substrate 10 (e.g., the first metallization layer 111) by means of a suitable connection layer 46. The holding pin 44 extends in a vertical direction y perpendicular to the substrate 10, and a second (free) end of the holding pin 44 faces away from the substrate 10. An outer diameter d442 of the holding pin 44 (e.g., the sleeve 442) in this example is smaller than the smallest diameter d74 of the holding element 74 (either the inner diameter d742, or the reduced diameter d744). An outer diameter d444 of the collar 444 is larger than the smallest diameter d74 of the holding element 74 (either the inner diameter d742, or the reduced diameter d744). Figure 8 illustrates the holding pin 44 and the holding element 74 in an unmounted state.

When the holding pin 44 is inserted into the holding element 74, the collar 444 is bent in a direction towards the substrate 10. That is, the holding pin 44 is pressed into the respective holding element 74 with a certain amount of force. After the collar 444 has been bent, it smoothly adapts to the inner contour of the holding element 74. That is, if the holding element 74 does not comprise any ribs 744, the collar 444 is bent along its entire circumference. If, however, the holding element 74 comprises ribs 744, the collar 44 may only be bent in certain sections defined by the ribs 744. In other sections, it may remain in its initial form, or may be bent only partly, for example. Deforming the collar 444 when pressing the holding pin 44 into the respective holding element 74 causes a force-fitting connection to be formed between the holding pin 44 and the respective holding element 74. In this way, a reliable connection between the housing 7 and the substrate 10 is formed which can withstand even comparably high press-out forces (e.g., press-out forces of 30N or even more).

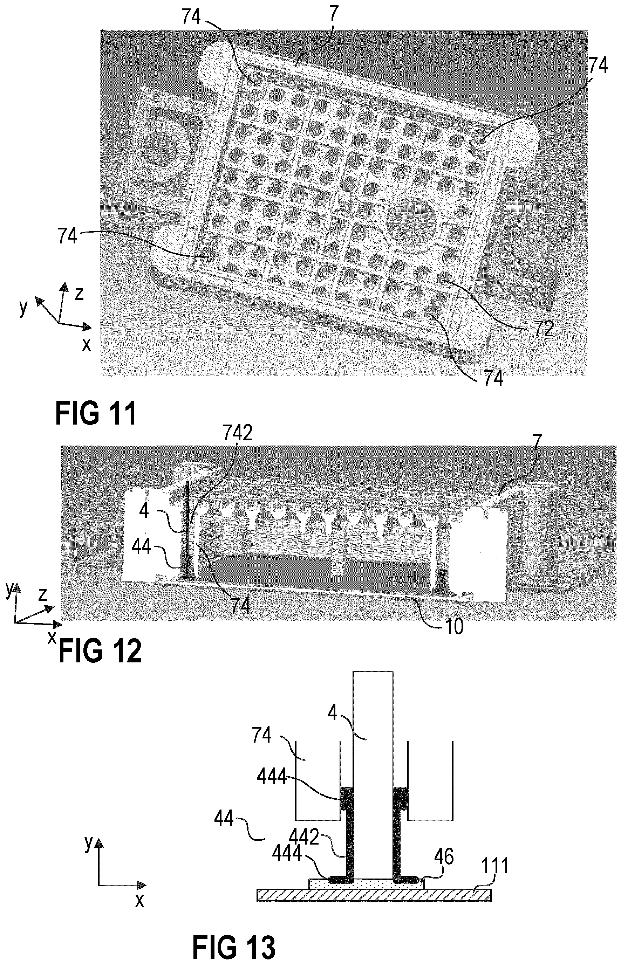

Now referring to Figure 10, a housing 7 for an exemplary power semiconductor module arrangement 100 is schematically illustrated that comprises four holding elements 74, wherein each holding element 74 is arranged at a different corner of the rectangular housing 7. In the example illustrated in Figure 10, each holding element 74 comprises four ribs 744. Figure 11 illustrates a similar arrangement with four holding elements 74. However, the holding elements 74 in the example of Figure 11 do not comprise any ribs 744 at all, similar to what has been described with respect to Figure 5C above. Instead of rectangular, the housing 7 in these examples can have a square shape instead.

As has been described above, the holding pins 44 are only used to provide a mechanical connection between the substrate 10 and the housing 7. When a holding pin 44 is implemented as a sleeve 442, however, it is possible that, in addition to mounting the housing 7 to the substrate 10, the holding pin 44 is used to accommodate a terminal element 4. A first end of a terminal element 4 may be inserted into the hollow holding pin 44 (sleeve), the holding pin 44 electrically and mechanically coupling the terminal element 4 to the substrate 10. In this example, the connection layer 46 may be an electrically conducting connection layer 46. The holding pin 44 in this example may also comprise an electrically conducting material, for example. A hollow holding pin 44 (sleeve) accommodating a terminal element 4 is exemplarily illustrated in the three-dimensional cross-sectional view of Figure 12 and in the cross-sectional view of Figure 13. The second end of the terminal element 4 may be electrically contacted from outside of the housing 7, similar to what has been described with respect to the terminal elements 4 in Figure 1 above.

The holding force exerted on the housing 7 (i.e., the holding elements 74) by means of a plurality of holding pins 44 may not be enough to permanently fix the housing 7 to the substrate 10 during the use of the power semiconductor module arrangement 100. When exposed to typical stress occurring during the use of the power semiconductor module arrangement 100, the force applied by the holding pins 44 may not be sufficient to hold the housing 7 in a desired position with regard to the substrate 10. The force, however, is generally sufficient to hold the housing 7 in a desired position with regard to the substrate 10 when shipping the power semiconductor module arrangement 100 to an end customer. When the power semiconductor module arrangement 100 is arranged on an additional base plate or heat sink at the customer, which is usually the case, the housing 7 is usually fixed to the base plate or heat sink permanently by means of additional holding elements, thereby also securing the substrate 10 in a desired position with regard to the housing 7 and the base plate or heat sink.

The arrangement of the holding pins 44 on the substrate 10 is not restricted to specific positions. One or more holding pins 44 can be arranged in any suitable positions of the substrate 10. That is, they can either be arranged close to the edges of the substrate 10 or anywhere centrally on the substrate 10. The number of holding pins 44 can be chosen in order to provide sufficient mechanical stability of the housing 7. According to one example, a power semiconductor module arrangement 100 comprises between 1 and 4, or between 1 and 8 holding pins 44. A housing 7 according to another example that comprises 14 holding elements 74 is schematically illustrated in Figure 14. The holding elements 74 illustrated in Figure 14 are implemented in different ways (different designs). A first holding element 74i, for example, has an oval shape with no ribs 744. A second and fourth holding element 74₂, 74₄ have a round shape with four 744 ribs, a third and sixth holding element 74₃, 74₆ have a round shape with two ribs 744, a fifth holding element 74s has a round shape with three ribs 744, and a seventh holding element 74₇ has a round shape with no ribs 744. The ribs 744 may generally be oriented in any direction. Holding elements 74 that are oriented in different directions are schematically illustrated at the top of Figure 14 (holding elements 74 arranged at the opposite side of the housing 7). Different designs of holding elements 74 may be combined in one housing 7, as is illustrated in Figure 14. It is, however, also possible that one housing 7 comprises a plurality of holding elements 74 that all have the same design. It is also possible to combine only two designs, or more than two designs in a single housing 7. As has been described above, alternatively or additionally to what is illustrated in Figure 14, any other shape of the holding element 74 and/or any other number of holding elements 744 is also possible.

Less than 14 or even more than 14 holding elements 74 are generally possible. When the housing 7 is mounted to the substrate 10, not every holding element 74 may accommodate a respective holding pin 44. Providing a large number of holding elements 74 may provide an increased flexibility. Each holding pin 44 that is arranged on the substrate 10 requires a certain amount of space. It is, however, generally desirable to keep the size of a substrate 10 as small as possible. The number of holding pins 44 may be chosen according to a minimum number of holding pins 44 that is required to hold the housing 7 in its desired position for shipping. This minimum number of holding pins 44 may depend on a size, material and weight of the substrate 10 and the housing 7, for example. Another important aspect, however, is the exact placement of the different components on the substrate 10. For different applications and designs there may be a different amount of space available for the holding pins 44 on the substrate 10. The exact placement of the holding pins 44 therefore may also depend on the application and the respective design. A housing 7 comprising more holding elements 74 than required (more holding elements 74 than holding pins 44), may be used for many different applications and designs, for example, as the exact placement of the holding pins 44 is not restricted to only few positions on the substrate 10.

The holding pins 44 and holding elements 74 described herein with regard to the different figures can be combined with each other in a single arrangement. That is, a power semiconductor module arrangement 100 can comprise holding elements 74 as described with respect to Figure 5A and/or holding elements 74 as described with respect to Figure 5B, and/or holding elements 74 as described with respect to Figure 5C. Alternatively or additionally, a power semiconductor module arrangement 100 may comprise holding elements 74 that are implemented in any other suitable way. Similarly, one or more holding pins 44 may be implemented as solid pins, and/or one or more holding pins 44 may be implemented as hollow pins, and/or one or more holding pins 44 may be implemented as sleeves, for example. Alternatively or additionally, a power semiconductor module arrangement 100 may comprise holding pins 44 that are implemented in any other suitable way.

## Claims

1. A power semiconductor module arrangement (100) comprising:
a housing (7);
a substrate (10) forming a ground surface of the housing (7);
one or more holding pins (44) mechanically connected to the substrate (10); and
one or more holding elements (74) attached to or integrally formed with the housing (7), wherein
a first end of each of the one or more holding pins (44) is arranged inside the housing (7) and connected to the substrate (10),
each of the one or more holding elements (74) comprises a sleeve configured to receive a free end of one of the holding pins (44), and
each of the one or more holding pins (44) extends from the substrate (10) in a vertical direction (y) perpendicular to a top surface of the substrate (10) towards a different one of the one or more holding elements (74) such that the free end (42) of each of the one or more holding pins (44) is arranged inside the respective holding element (74) in order to form a force-fitting connection.

2. The power semiconductor module arrangement (100) of claim 1 comprising a single holding element (74) arranged in a central position of a cover of the housing (7).

3. The power semiconductor module arrangement (100) of claim 1 comprising two holding elements (74) arranged on opposing sides of the housing (7).

4. The power semiconductor module arrangement (100) of claim 1 comprising four holding elements (74), wherein the housing (7) has a rectangular or square cross-section, and each holding element (74) is arranged at a different corner of the housing (7).

5. The power semiconductor module arrangement of claim 1 comprising more holding elements (74) than holding pins (44).

6. The power semiconductor module arrangement (100) of any of claims 1 to 5, wherein at least one of the one or more the holding elements (74) comprises a sleeve (742) having an inner diameter (d742).

7. The power semiconductor module arrangement (100) of claim 6, further comprising a plurality of ribs (744) extending from inner diameter (d742) of the sleeve (742) towards a center of an opening defined by the sleeve (742), the ribs (744) defining a reduced diameter (d744) in defined sections of the sleeve (742), wherein the reduced diameter (d744) is smaller than the inner diameter (d744).

8. The power semiconductor module arrangement (100) of claim 6 or 7, wherein
at least one of the one or more holding pins (44) comprises a collar (444) arranged at the free end of the respective holding pin (44),
an outer diameter (d442) of the holding pin (44) is smaller than a smallest diameter (d74, d742, d744) of the holding element (74), and
the collar (444) is bent in a direction towards the substrate (10) and smoothly adapts to the inner contour of the holding element (74).

9. The power semiconductor module arrangement (100) of claim 7, wherein an outer diameter of a holding pin (44) is equal to or larger than the reduced diameter (d744) defined by the ribs (744) and smaller than the inner diameter (d742) of the sleeve (742).

10. The power semiconductor module arrangement (100) of any of the preceding claims, wherein
at least one of the one or more holding pins (44) comprises a sleeve (442),
the power semiconductor module arrangement (100) further comprises at least one terminal element (4), wherein a first end of a different one of the at least one terminal element (4) is arranged in one of the at least one sleeve (442),
a second end of the at least one terminal element (4) extends vertically to the outside of the housing (7), and
the respective holding pin (44) electrically and mechanically couples the respective terminal element (4) to the substrate (10).

11. The power semiconductor module arrangement of any of the preceding claims, further comprising a connection layer between each of the plurality of holding pins (44) and the substrate (10).

12. The power semiconductor module arrangement of claim 11, wherein the connection layer comprises at least one of
a solder layer;
an electrically conductive adhesive;
an electrically insulating adhesive; and
a layer of a sintered metal powder.

13. A method for assembling a power semiconductor module arrangement (100), the method comprising:
mechanically connecting one or more holding pins (44) to a substrate (10); and
arranging a housing (7) on the substrate (10), wherein
one or more holding elements (74) are attached to or integrally formed with the housing (7),
a first end of each of the one or more holding pins (44) is arranged inside the housing (7) and connected to the substrate (10),
each of the one or more holding elements (74) comprises a sleeve configured to receive a free end of one of the one or more holding pins (44), and
each of the one or more holding pins (44) extends from the substrate (10) in a vertical direction (y) perpendicular to a top surface of the substrate (10) towards a different one of the one or more holding elements (74), and arranging the housing (7) on the substrate (10) comprises pressing the free end of each of the one or more holding pins (44) into a different one of the one or more holding elements (74) in order to form a force-fitting connection.

14. The method of claim 13, wherein
at least one of the one or more holding pins (44) comprises a collar (444) arranged at the free end of the respective holding pin (44),
an outer diameter (d442) of the holding pin (44) is smaller than a smallest diameter (d74, d742, d744) of the holding element 74, and
when pressing the free end of each of the one or more holding pins (44) into one of the holding elements (74), the collar (444) of the respective one of the holding pins (44) is bent in a direction towards the substrate (10).

## Amended claims

### Amended claims in accordance with Rule 137(2) EPC.

1. A power semiconductor module arrangement (100) comprising:
a housing (7);
a substrate (10) forming a base surface of the housing (7);
one or more holding pins (44) mechanically connected to the substrate (10); and
one or more holding elements (74) attached to or integrally formed with the housing (7), wherein
a first end of each of the one or more holding pins (44) is arranged inside the housing (7) and connected to the substrate (10),
each of the one or more holding elements (74) comprises a sleeve configured to receive a free end of one of the holding pins (44),
each of the one or more holding pins (44) extends from the substrate (10) in a vertical direction (y) perpendicular to a top surface of the substrate (10) towards a different one of the one or more holding elements (74) such that the free end (42) of each of the one or more holding pins (44) is arranged inside the respective holding element (74) in order to form a force-fitting connection,
at least one of the one or more holding pins (44) comprises a sleeve (442),
the power semiconductor module arrangement (100) further comprises at least one terminal element (4), wherein a first end of at least one of the at least one terminal element (4) is arranged in a different one of the at least one sleeve (442),
a second end of the at least one terminal element (4) extends vertically to the outside of the housing (7), and
the respective holding pin (44) electrically and mechanically couples the respective terminal element (4) to the substrate (10).

2. The power semiconductor module arrangement (100) of claim 1 comprising exactly one holding element (74) arranged in a central position of a cover of the housing (7).

3. The power semiconductor module arrangement (100) of claim 1 comprising two holding elements (74) arranged on opposing sides of the housing (7).

4. The power semiconductor module arrangement (100) of claim 1 comprising four holding elements (74), wherein the housing (7) has a rectangular or square cross-section, and each holding element (74) is arranged at a different corner of the housing (7).

5. The power semiconductor module arrangement of claim 1 comprising more holding elements (74) than holding pins (44).

6. The power semiconductor module arrangement (100) of any of claims 1 to 5, wherein at least one of the one or more the holding elements (74) comprises a sleeve (742) having an inner diameter (d742).

7. The power semiconductor module arrangement (100) of claim 6, further comprising a plurality of ribs (744) extending from inner diameter (d742) of the sleeve (742) towards a center of an opening defined by the sleeve (742), the ribs (744) defining a reduced diameter (d744) in defined sections of the sleeve (742), wherein the reduced diameter (d744) is smaller than the inner diameter (d744).

8. The power semiconductor module arrangement (100) of claim 6, wherein
at least one of the one or more holding pins (44) has a collar (444) arranged at its free end,
an outer diameter (d442) of the holding pin (44) is smaller than the inner diameter (d742) of the holding element (74), and
the collar (444) is bent in a direction towards the substrate (10) and smoothly adapts to the inner contour of the holding element (74).

9. The power semiconductor module arrangement (100) of claim 7, wherein
at least one of the one or more holding pins (44) has a collar (444) arranged at its free end,
an outer diameter (d442) of the holding pin (44) is smaller than the reduced diameter (d744) defined by the ribs (744) of the holding element (74), and
the collar (444) is bent in a direction towards the substrate (10) and smoothly adapts to the inner contour of the holding element (74).

10. The power semiconductor module arrangement (100) of claim 7, wherein an outer diameter of a holding pin (44) is equal to or larger than the reduced diameter (d744) defined by the ribs (744) and smaller than the inner diameter (d742) of the sleeve (742).

11. The power semiconductor module arrangement of any of the preceding claims, further comprising a connection layer between each of the one or more holding pins (44) and the substrate (10).

12. The power semiconductor module arrangement of claim 11, wherein the connection layer comprises at least one of
a solder layer;
an electrically conductive adhesive; and
a layer of a sintered metal powder.

13. A method for assembling a power semiconductor module arrangement (100), the method comprising:
mechanically connecting one or more holding pins (44) to a substrate (10); and
arranging a housing (7) on the substrate (10), wherein
one or more holding elements (74) are attached to or integrally formed with the housing (7),
a first end of each of the one or more holding pins (44) is arranged inside the housing (7) and connected to the substrate (10),
each of the one or more holding elements (74) comprises a sleeve configured to receive a free end of one of the one or more holding pins (44),
each of the one or more holding pins (44) extends from the substrate (10) in a vertical direction (y) perpendicular to a top surface of the substrate (10) towards a different one of the one or more holding elements (74), and arranging the housing (7) on the substrate (10) comprises pressing the free end of each of the one or more holding pins (44) into a different one of the one or more holding elements (74) in order to form a force-fitting connection,
at least one of the one or more holding pins (44) comprises a sleeve (442),
the power semiconductor module arrangement (100) further comprises at least one terminal element (4), wherein a first end of at least one of the at least one terminal element (4) is arranged in a different one of the at least one sleeve (442),
a second end of the at least one terminal element (4) extends vertically to the outside of the housing (7), and
the respective holding pin (44) electrically and mechanically couples the respective terminal element (4) to the substrate (10).
